# EUROPEAN PATENT APPLICATION

(11) **EP 0 908 945 A2**
(43) Date of publication of application: **14.04.1999**
(21) Application number: 98113442.2
(22) Date of filing: 18.07.1998
(51) Int. Cl.: H01L 21/768

(54) **Dual damascene with self aligned via interconnects**

(30) Priority: 29.09.1997 US 939149
(71) Applicant: SIEMENS AKTIENGESELLSCHAFT, 80333 München (DE)
(72) Inventor: Schnabel, Rainer F., Wappingers Falls, NY 12590 (US); Feldner, Klaus, 01109 Dresden (US)
(74) Representative: Patentanwälte Westphal, Mussgnug & Partner

(57) **Abstract**

An improved method of performing a dual damascene etch through a layer stack disposed above a substrate using self aligned vias. The layer stack includes an underlying conductive layer and an insulating layer disposed above the underlying conductive layer. The method includes the following operative steps. A layer of hard resist is deposited upon a top surface of the insulating layer patterned such that a first opening in the hard resist layer is positioned over the underlying device layer. A layer of soft resist is then deposited upon the top surface of the hard resist, the soft resist has a second opening smaller than and aligned to the first opening and the underlying conductive layer. A first trench is then formed in the top surface of the insulating layer positioned over and separated from the underlying device layer by insulating material at a bottom of the trench. The soft resist is then removed without substantially affecting the hard resist. The via is formed by etching through the insulator material at the bottom of the trench down to the underlying device layer.

## Description

### BACKGROUND OF THE INVENTION

### 1. Field of the Invention

The present invention relates to semiconductor devices and more particularly, to improved methods of forming multi-level coplanar metal/insulator films using dual damascene with self aligned via interconnects.

### 2. Description of the Related Art

Semiconductor manufacturers must continually improve the power and performance of semiconductor devices while keeping the device size to a minimum. In an effort to maintain a small device size, most semiconductor manufacturers reduce individual components of the device to minimal dimensions. Further, manufacturers are vertically integrating more and more of these components, as opposed to using only horizontal integration, to reduce the device area consumed by the components. Vertical integration is typically achieved by using several conductive layers in the device and interconnecting these layers using, for example, inter-level contacts known in the art as vias or via interconnects.

As individual component dimensions become smaller, it becomes more difficult to interconnect the various conductive layers. A recent approach to solving the problem of interconnecting the various conductive layers involves etch and mask sequences generally known in the art as damascene techniques. The damascene technique involves forming a plurality of trenches in a layer of insulator and subsequently filling them with metal which is then polished down to the surface of the insulator to form the desired metal pattern. In a process generally known as dual damascening, both the metal trenches as described above and the via interconnects electrically connecting the aforementioned metal pattern and various other conductive layers are typically filled substantially simultaneously.

In the conventional dual damascene technique, via interconnects are typically formed substantially simultaneously with the overlying metallization. This technique requires that the holes through the insulator (the holes will eventually be filled with metal or other conductive material to form the via) be formed prior to the deposition of the layer of photoresist used in the subsequent metallization lithography.

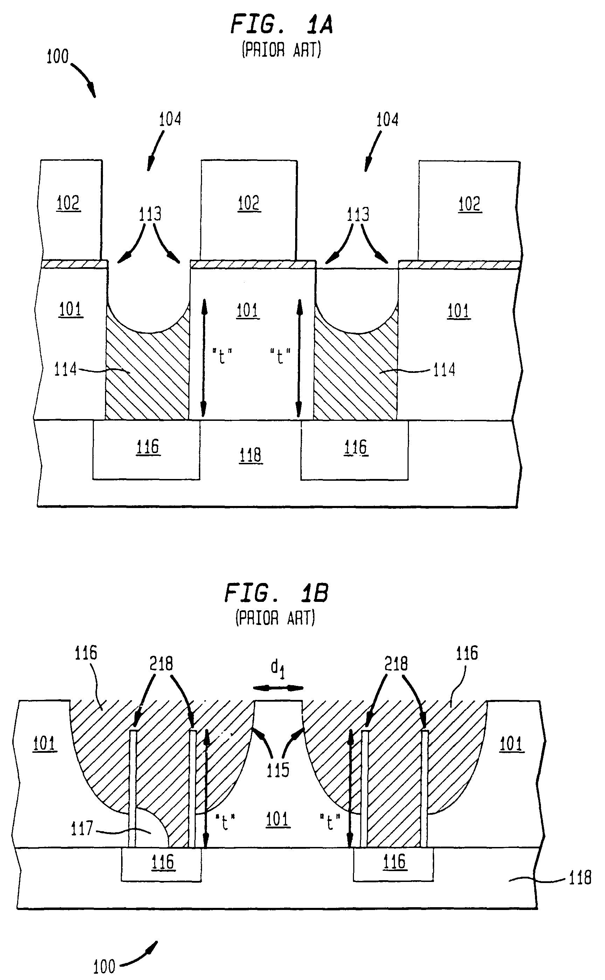

FIGURE 1A represents a cross sectional view of a stacked semiconductor structure 100. Stacked semiconductor structure 100 includes a semiconductor substrate 118, an underlying conductive layer 116 overlaid with a layer of insulator 101. A plurality of adjacent via holes 104 used to electrically interconnect various coplanar conductive layers is formed by dual damascene technique as described above. In the conventional dual damascene technique, the overlying metal lithography is performed after via holes 104 have been formed in insulator 101. Via holes 104 may be sized larger than the actual contact area of underlying metallization layer 116 in order to assure proper alignment of via holes 104 to the underlying metallization layer 116.

After the via holes 104 have been formed, a layer of anti-reflective coating 113 (known in the art and referred hereinafter as ARC) is conventionally deposited upon the upper surface of the layer of insulator 101. The ARC deposition operation results in a layer of ARC residue 114 unavoidably deposited in via holes 104 to a height approximately a distance "t" above the upper surface of conductive layer 116. A layer of metal lithography photoresist is then conventionally deposited upon the upper surface of ARC layer 113. The photoresist is subsequently developed and removed by a conventional photoresist strip process to form the metallization resist pattern 102. However, ARC material 114 within via holes 104 is substantially unaffected by the metallization photoresist strip operation.

Referring to FIGURE 1B, the portion of ARC layer 113 unprotected by resist pattern 102 is be removed prior to the formation of trenches 115. ARC layer 113 is removed by exposing the stacked semiconductor structure 100 to a first etch process designed to break through organic ARC layer 113. This first break through etch is followed by a second anisotropic etch designed to create a trench 115 in the insulator 101 into which a metal 116 or other conductive material is subsequently deposited. However, ARC residue 117 remaining within via holes 104 react with various etch by-products to form a sidewall structure. The sidewall structure formed substantially inhibits the action of both the first ARC break through etch and the second oxide etch used to form trenches 115 resulting in what is referred to in the art as a fence 218. Fence 218 is generally substantially the same height "t" as the ARC residue remaining within the via hole 104 as discussed above.

With the dual damascene technique, the overlying metallization and associated vias are formed substantially simultaneously by depositing metal 116 within trenches 115 by a metal deposition process (sputtering process, for example) followed by metal reflow. As is known in the art, proper metal reflow is highly dependent upon the surface geometry of the surface onto which the metal is deposited. The presence of fence 218 within via holes 104 disrupts the flow of metal 116 thereby preventing a smooth flow of metal 116 into via holes 104. This disruption of the flow of metal into via holes 104 may result in the formation of voids 117 within via holes 104, the presence of which substantially increases the electrical contact resistance of the vias. The presence of the metal voids 117 may also present unacceptable reliability problems since all the current flowing through each via must be carried by the unvoided metalized portions of the via. High current densities through the unvoided portions of the via may result in electromigration of the via metal. Electromigration of the via metal may result in long term unacceptable Failure In Time (FIT) rates. In some instances, fences 218 may cause the formation of an electrical open by preventing sufficient metal flow into via hole 104.

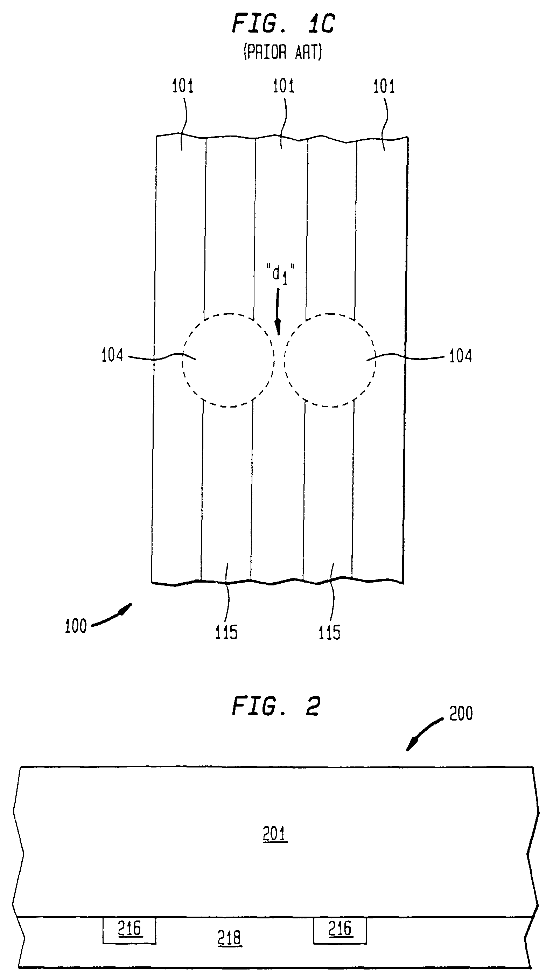

Referring to Figure 1B and Figure 1C, an additional problem associated with the conventional dual damascene technique relates to the practice of oversizing the vias 104 in the attempt to properly align to the underlying conductive layer 116. Referring first to Figure 1B, oversizing vias 104 may result in a reduced thickness "d₁" of insulator 101(otherwise referred to as interspacing) electrically and physically separating adjacent vias 104. This reduced thickness "d₁" may result in electrical breakdown or electrical current leakage between vias 104 which may result in potential catastrophic temperature related failures that are difficult to screen out in post manufacturing testing. Reliability failures evident after only substantial accelerated high temperature reliability testing may also be present due to the small distance between regions of high current densities such as via holes 104 exacerbated by the presence of fences 218 as discussed above.

Referring to now to Figure 1C which shows a top view of the surface of stacked semiconductor structure 100 along a cross sectional slice "b" of Figure 1B illustrating the proximity of vias 104. In the structure shown, the proximity of vias 104 may result in significant manufacturing or long term reliability problems related to the various defects described above.

Thus there is a need for dual damascene techniques which eliminate the possibility of forming fences within via holes, allow the formation of vias which self align to the underlying metallization layer, and allow vias to be closely spaced without creating substantial probability of post fabrication yield loss or subsequent field failures.

### Summary of the Invention

Broadly speaking, the present invention relates to semiconductor devices and more particularly, to an improved method of performing a dual damascene etch with self aligned vias through a layer stack disposed above a substrate. According to one embodiment of the invention, the layer stack includes an underlying conductive layer and an insulating layer disposed above the underlying conductive layer. The method includes the following operative steps. A layer of hard resist is deposited upon a top surface of the insulating layer patterned such that a first opening in the hard resist layer is positioned over the underlying device layer. In a preferred embodiment, the hard resist layer is composed of silicon oxynitride. Next, a layer of soft resist is deposited upon a top surface of the hard resist, the soft resist having a second opening smaller than and aligned to the first opening in said hard resist. A trench as defined by the second opening is then formed in the top surface of the insulating layer positioned over and separated from the underlying device layer by insulating material at a bottom of the trench. The soft resist is then removed without substantially affecting the hard resist. The via is formed by etching through the insulator material at the bottom of the trench down to the underlying device layer.

In another embodiment, a method of forming a via configured for connecting an underlying device layer and an overlying conductor of a layer stack, the overlying conductor configured to be disposed in a trench formed in an insulating layer and spaced apart from the underlying device layer by insulating material at a bottom of the trench is disclosed. The method includes the following operative steps. Firstly, depositing a hard mask layer over the top surface of said insulating layer, the hard mask having a first opening corresponding to the position of the trench to be formed. Next, depositing a soft mask layer on top of the hard mask layer, the soft mask layer having a second opening corresponding to the location of the via to be formed. Finally, forming the via by etching through the insulating material at the bottom of the trench down to at least the underlying device layer.

Other aspects and advantages of the invention will become apparent from the following detailed description, taken in conjunction with the accompanying drawings, illustrating by way of example the principles of the invention.

### Brief Description of the Drawings

The present invention is illustrated by way of example, and not by way of limitation, in the figures of the accompanying drawings. In the following figures, like reference numerals refer to analogous or similar elements to facilitate ease of understanding.
FIGURE 1A is a cross sectional illustration of a stacked semiconductor structure including an underlying conductive layer overlaid with a layer of insulator having a via hole formed by conventional dual damascene techniques.
FIGURE 1B is a cross sectional illustration of the stacked semiconductor structure as shown in FIGURE 1A showing the subsequent formation of trenches suitable for the deposition of metal or other conductive material.
FIGURE 1C is a diagrammatic top view of the stacked semiconductor structure as shown in FIGURE 1B along a section 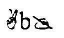 showing the relative position of oversized adjacent vias formed in conventional damascene techniques.
FIGURE 2 illustrates a cross sectional view of a stacked semiconductor structure having an insulator layer overlaying a substrate which includes an underlying conductive layer in accordance with one embodiment of the present invention.
FIGURE 3 illustrates in accordance with an embodiment of the invention a cross sectional view of the stacked semiconductor structure as shown in FIGURE 2 subsequent to the deposition of a hard resist layer patterned to include a first opening corresponding to the location of the underlying substrate.
FIGURE 4 illustrates in accordance with an embodiment of the invention a cross sectional view of the stacked semiconductor structure as shown in FIGURE 3 subsequent to the deposition of a soft resist layer patterned to include a second opening smaller than and aligned to the first opening included in the hard resist layer.
FIGURE 5A illustrates in accordance with an embodiment of the invention a cross sectional view of the stacked semiconductor structure as shown in FIGURE 4 subsequent to the etching of a first trench extending to a depth at least about midway to the underlying conductive layer.
FIGURE 5B illustrates in accordance with an embodiment of the invention a cross sectional view of the stacked semiconductor structure as shown in FIGURE 5A subsequent to the etching of a via extending to the underlying conductive layer.
FIGURE 6 illustrates in accordance with an embodiment of the invention a cross sectional view of the stacked semiconductor structure as shown in FIGURE 5B subsequent to the deposition of a metal or other conductive material to electrically connect the overlying metallization to the underlying conductive layer.
FIGURE 7 is an illustrative top view of the stacked semiconductor structure as shown in FIGURE 6 showing the relative positions of vias in relation to the insulative interspacing regions along a cross sectional cut "c" in accordance with an embodiment of the invention.
Figure 8 is a flowchart of the method of using dual damascene to from multi-level coplanar metal/insulator films with self aligned via interconnects in accordance with one embodiment of the invention.

### Detailed Description of the Invention

The present invention will now be described in detail with reference to a few illustrative embodiments thereof as illustrated in the accompanying drawings. In the following description, numerous specific details are set forth in order to provide a thorough understanding of the present invention. It will be apparent, however, to one skilled in the art, that the present invention may be practiced without some or all of these specific details. In other instances, well known process steps have not been described in detail in order to not unnecessarily obscure the present invention.

The invention relates to the formation of forming mult-level coplanar metal/insulator films for use in integrated circuits (ICs). The ICs include, for example, random access memories (RAMs) such as dynamic RAMs (DRAMs), synchronous DRAMs (SDRAMs), or a read only memory (ROM). Other ICs such as application specific ICs (ASICs), merged DRAM-logic circuits (embedded DRAMs), or other logic circuits are also useful.

Typically, numerous ICs are formed on the wafer in parallel. After processing is finished the wafer is diced to separate the ICs to individual chips. The chips are then packaged, resulting in a final product that is used in, for example, consumer products such as computer systems, cellular phones, personal digital assistants (PDAs), and other electronic products.

In accordance with the invention, an improved method for multi-level coplanar metal/insulator films having self aligned vias is provided. According to one aspect of the present invention, a dual damascene technique is used which incorporates a first hard mask to form overlying metallization trenches and a soft resist mask to form self aligned vias which electrically connect the overlying metallization layer to an underlying device layer.

In one embodiment of the invention, a via is formed through an insulator layer to an underlying device layer using a dual damascene etch with a hard mask composed of silicon oxynitride. In this embodiment, the hard mask includes a first opening suitable for the formation of the abovemention metallization trenches. A soft resist mask is then deposited upon the hard resist mask. The soft resist mask includes a second opening smaller than and aligned with the first opening of the hard mask. The second opening is aligned to the underlying conductive layer and is used to form a first trench extending at least about midway to the underlying conductive layer. After formation of the first trench, the soft resist layer is removed without substantially affecting the first hard layer. A second anisotropic etch then forms a second trench having a first portion integrally formed with a second portion. The first portion extends from the bottom of the first trench to at least the underlying conductive layer and is suitable for forming the via interconnect. The second portion is defined by the first opening of the hard mask and is suitable for receiving deposited metal to form the overlying metalization layer. The via thus formed is free of any fences since no photoresist or ARC is deposited upon the surface of the semiconductor stacked structure after formation of the first trench. Additionally, since the hard mask is used to define the external configuration of the via, the distance between the vias can be readily controlled.

Embodiments of the invention are discussed below with reference to Figure 2 through Figure 6. However, those skilled in the art will readily appreciate that the detailed description given herein with respect to these figures is for explanatory purposes as the invention extends beyond these limited embodiments.

Figure 2 illustrates a cross sectional view of a stacked semiconductor structure 200 having an insulator layer 201 overlaying a substrate 218 which includes an underlying conductive layer 216 in accordance with one embodiment of the present invention. The stacked semiconductor structure 200 may, for example, represent a stacked semiconductor structure employed to fabricate a conventional transistor such as an n FET or p FET (field effect transistor). Insulator layer 201 may be deposited on the substrate 218 of a pre-determined conductivity type. Chemical vapor deposition (CVD) or a similar technique may be employed to deposit insulator 201, which typically includes planarized silicon dioxide, such as TEOS, a glass material such as reflowed phosphosilicate glass, or a polymer like polyimide. In the described embodiment, insulator layer 201 is formed over previously defined substrate 218, which includes previously defined conductive layer 216. The conductive layer 216 may be a portion of an underlying metallization layer. Alternatively, the conductive layer 216 may represent a highly doped silicon layer, a conductive metal such as tungsten, or a portion of any type of active device such as, for example, the source or drain region of a transistor. In this embodiment, the insulator layer 216 may have a thickness in the range of 0.9 micron to about 2.0 microns.

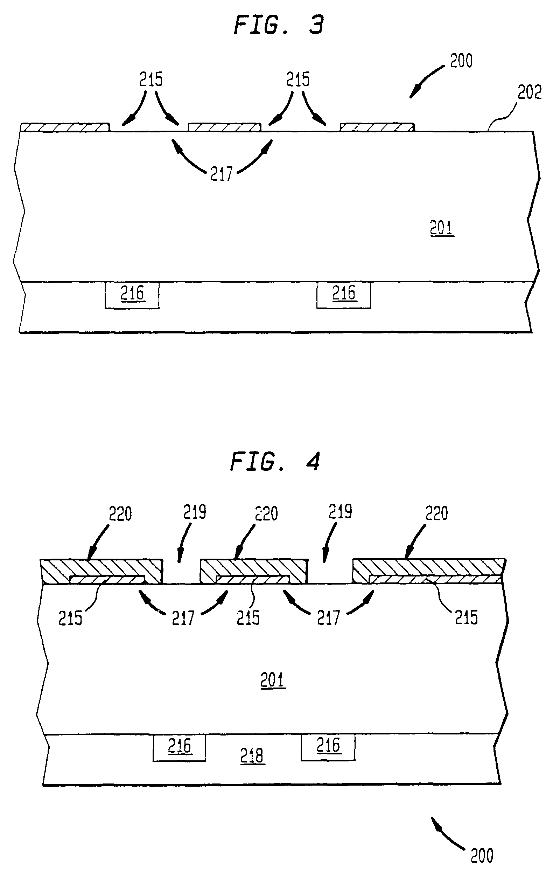

Referring to Figure 3, insulator layer 201 has an upper surface 202 upon which a hard resist layer 215 has been deposited by any technique known to those of ordinary skill in the art. The hard resist may have a thickness of about 1000Å and may be composed of silicon nitride or, in a preferred embodiment, silicon oxynitride. The formation of a first opening 217 located above the underlying conductive layer is accomplished by conventional photolithographic techniques well known to those skilled in the art. In one embodiment, such a method of forming first opening 217 is referred to as reactive ion etching (referred to as RIE) utilizing N₂ as an etchant gas. In one embodiment, if the hard resist layer 215 is composed of silicon nitride, a layer of organic anti-reflective coating (not shown) referred to as ARC is preferably applied to the upper surface of the hard resist layer 215. However, in the preferred embodiment, use of silicon oxynitride for hard mask 215 eliminates the need for use of ARC. For clarity of this discussion, it is presumed that hard layer 215 is composed of silicon oxynitride and no ARC layer is required. However, as noted above, use of silicon nitride or any other appropriate compound for hard mask 215 may require the additional step or steps related to ARC deposition and removal.

Once hard resist layer 215 has been suitably deposited and appropriately patterned, as described above, a soft resist layer 220 of about 1000Å thickness is deposited upon hard resist layer 215 using convention deposition processes and procedures as shown in Figure 4. The soft resist layer 220 is patterned utilizing conventional photolithographic processes and procedures to include a second opening 219 smaller than and aligned to first opening 217 of hard mask 215 as shown in Figure 4.

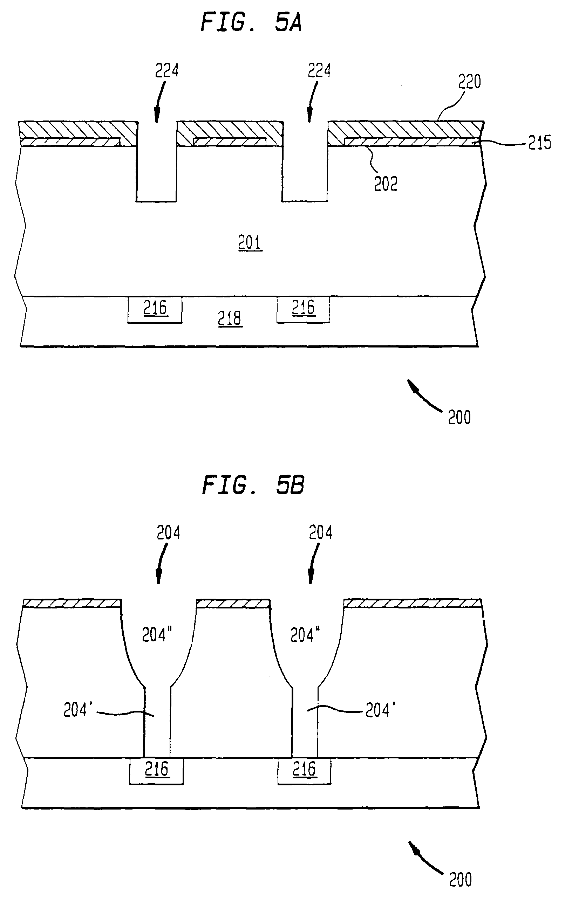

The second opening 219 is disposed and sized to form a first trench 224 by a first anisotropic etch which removes sufficient insulator material from insulator layer 201 to form first trench 224 as shown in Figure 5A. One such method of removing insulator material is by way of an RIE etch, as described above, using for example, Ar, C₄F₈, CO and/or O₂ as reactive gases. (It should be noted that in the described embodiment since hard resist 215 is composed of silicon oxynitride, no ARC layer is required and thus no ARC removal step is necessary) In the described embodiment, first trench 224 may have its bottom extend to a point about midway between upper surface 202 and underlying conductive layer 216. In another embodiment, first trench 224 may have its bottom extend to a point substantially near or extending to underlying conductive layer 216.

After via hole 224 has been formed, soft resist layer 220 is removed by any conventional means so as to leave hard resist mask 215 substantially unaffected. In this manner, first opening 217 may be used to form trenches suitably disposed to ultimately form the overlying metallization layer. Since no ARC or photoresist is deposited after the formation of first trench 224, there is no possibility of the formation of the aforementioned fences and the problems associated therewith. Referring now to Figure 5B, in the described embodiment, a second anisotropic etch may be used to form a second trench 204 having a first portion 204' and a second portion 204'' wherein first portion 204' extends substantially to underlying conductive layer 216 while second portion 204'' is arranged to form the desired overlying metallization pattern. It should be noted that underlying conductive layer 216 may be used as an etch stop whereby the second anisotropic etch process is halted once a pre-determined amount of the constituent material forming underlying conductive layer is evident in the plasma used in the second anisotropic etch process.

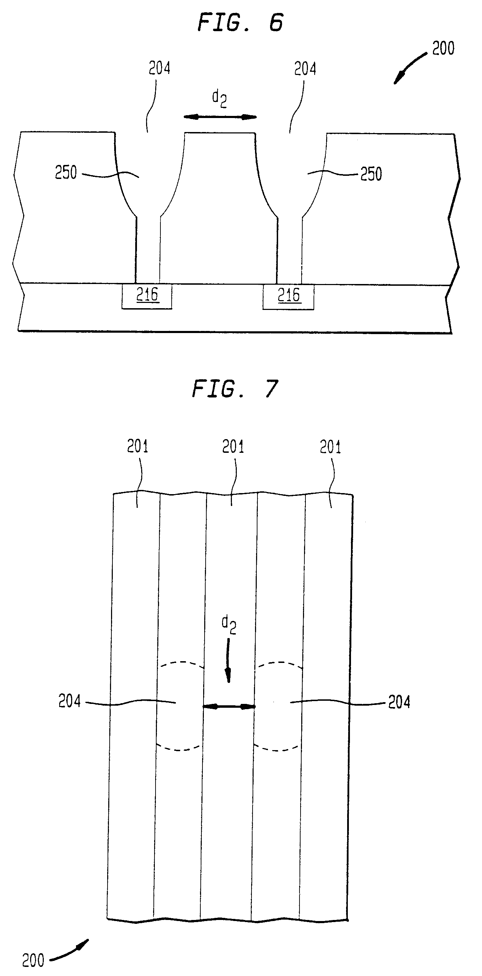

After completion of the second anisotropic etch and final formation of second trench 204 is complete, hard resist layer 215 is removed by any conventional technique leaving the structure as illustrated in Figure 6. At this point in the process, the overlying metallization layer is ready to be formed by depositing a metal 250 by any appropriate metallization technique. Metallization techniques are well known in the art and described, for example in VLSI technology, 2nd Edition, S.M. Sze 1988 McGraw-Hill Publishing Company. Suitable metals and alloys for forming the metallization layer include, for example, aluminum, copper, nickel, molybdenum, tungsten, platinum, tantalum disilicide, titanium disilicide, as well as other alloys of these materials. Aluminum, aluminum alloys such as aluminum silicon, copper, and tungsten are often the materials of choice for interconnection metallization.

The metals may be deposited by known techniques such as chemical vapor deposition (CVD), physical vapor deposition (PVD), or low pressure chemical vapor deposition (LPCVD). The selection of particular equipment and process parameters for CVD, PVD and LPCVD is within the ability one skilled in the art of semiconductor processing. Deposition of the metal (usually in blanket fashion over the entire surface of the stacked semiconductor structure 200) fills first portions 204' and second portion 204'' of trench 204 thereby substantially simultaneously creating the overlying metallization layer and the vias interconnecting the overlying metalization layer and the underlying conductive layer 216.

It should be evident from Figures 5A and Figure 5B, that the first and second anisotropic etch is related by the extent that first trench 224 is etched into insulator layer 201. As can be seen, if first anisotropic etch forms extends first trench 224 to a point proximate to the position of underlying conductive layer 216, then the resulting second anisotropic etch will typically be of shorter duration since less insulator material must be etched resulting in a modified first portion 204' and second portion 204'', respectively. This ability to substantially modify the form and structures formed simply by increasing or decreasing the applied etch times offers substantial advantages over more conventional processes.

FIGURE 7 is an illustrative top view of the stacked semiconductor structure as shown in FIGURE 6 showing the relative positions of vias in relation to the insulative interspacing regions. As one may note, the shape of vias formed coincide with the insulative interspacing regions 201 defined by hard mask 215, thus eliminating the encroachment problem so evident with conventional dual damascene techniques. The ability to place vias 204 as illustrated, improves the ability of the designer to route and place integrated circuit interconnections by reducing the problems associated with encroachment of the insulative interspacing regions 201 as evidenced by the increased inter-via spacing d₂.

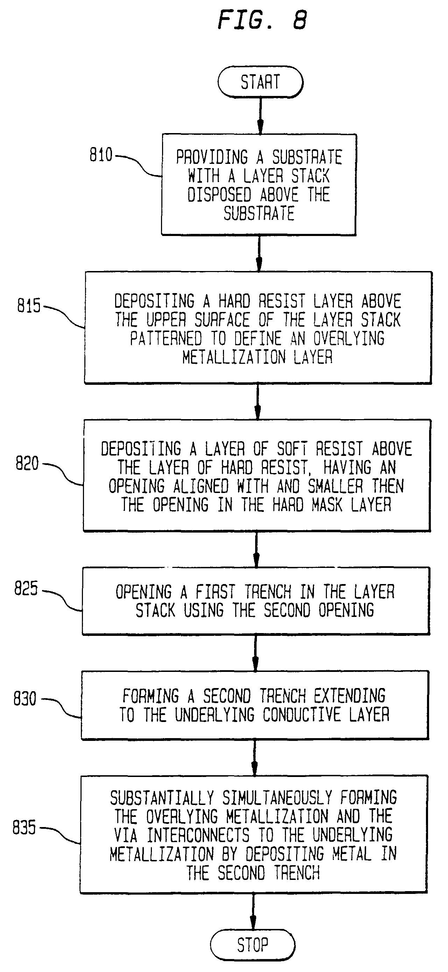

The formation of multi-level coplanar metal/insulator films using dual damascene techniques using self aligned vias is detailed in the flowchart illustrated by FIGURE 8 may include the following operative steps.

In step 810, a substrate with a layer stack disposed above the substrate is provided. The layer stack includes an underlying device layer and an insulating layer disposed above said underlying device layer. With reference to FIGURE 2, the substrate is shown as substrate 218 and the underlying device layer is shown as conductive layer 216. Insulator layer 201 is shown disposed above the substrate 218 and the underlying conductive layer 216.

In step 815, a layer of hard resist is deposited upon the upper surface of the layer stack having a first opening patterned to define an overlying metallization layer, the first opening being positioned substantially above the underlying device layer. With reference to FIGURE 3, the layer of hard resist is shown as hard resist 215 and the opening is shown as first opening 217.

In step 820, a layer of soft resist is deposited on the layer of hard resist, the soft resist includes a second opening smaller than and aligned with the first opening, the second opening being for forming a via interconnection to the underlying conductive layer. With reference to Figure 4, the soft resist mask is shown as soft resist mask 220 and its associated opening is shown as second opening 222.

In step 825, a first trench is formed extending to a point about midway through the insulator layer. As shown in Figure 5A, the first trench 224 is substantially aligned to the underlying conductive layer 216 and extends to about midway through insulator layer 201. In some cases, however, it is permissible, and even desirable, to extend first trench 224, to a point near or extending to underlying conducive layer 216.

In step 830, a second anisotropic etch is performed to form a second trench after removal of the soft resist layer without substantially affecting the hard resist layer. The second anisotropic etch uses the underlying conductive layer as an etchstop forming the structures as illustrated in Figure 5B.

In step 835, the hard resist layer is removed and a metal or other conductive material is deposited within the aforementioned trench substantially simultaneously forming both the overlying metallization layers and the associated via interconnects to the underlying conductive layer.

Many advantages may be realized by utilization of the described method of performing the inventive dual damascene etch to form a via. One such advantage is the fact the dual damascene technique using self aligned vias as described does not result in the formation of fences since the via holes are formed after the deposition of all photoresist layers and ARC material, if any.

Another advantage of the invention relates to the fact that the ultimate shape of the vias substantially conform to the boundaries formed by the insulative interspacing regions. This conformity allows closer spacing of vias without the problems heretofore associated with conventional damascene techniques.

The many features and advantages of the present invention are apparent from the written description, and thus, it is intended by the appended claims to cover all such features and advantages of the invention. Further, since numerous modifications and changes will readily occur to those skilled in the art, it is not desired to limit the invention to the exact construction and operation as illustrated and described. Hence, all suitable modifications and equivalents may be resorted to as falling within the scope of the invention.

## Claims

**1.** A method of performing a dual damascene etch through a layer stack disposed above a substrate, said layer stack comprising an underlying device layer, an insulating layer disposed above said underlying device layer, said method comprising:
depositing a layer of hard resist above a top surface of said insulating layer, said layer of hard resist being patterned such that a first opening in said layer of hard resist is positioned over said underlying device layer, said first opening suitably arranged to define an overlying metallization;
depositing a layer of soft resist above a top surface of said hard resist, said soft resist being patterned such that a second opening smaller than and aligned to said first opening in said hard resist is formed, said second opening suitably disposed to form a via interconnect coupling said overlying metallization layer and said underlying metallization layer;
forming a trench in said top surface of said insulating layer using said second opening as a first mask opening, said trench being positioned over said underlying device layer and separated therefrom by insulating material at a bottom of said trench;
removing said soft resist such that said hard resist is substantially unaffected; and
forming a via by etching, using the first opening as a second mask opening, through said insulating material at bottom of said trench down to said underlying device layer.

**2.** The method of claim 1 wherein said hard resist is SiN.

**3.** The method of claim 2 further comprising:
depositing an anti-reflective layer above said top surface of said hard resist to facilitate said etching through said soft resist and said insulating material.

**4.** The method of claim 3 further comprising:
performing a break-through etch of said anti-reflective layer prior to said etching through said hard resist.

**5.** The method of claim 4 wherein said break-through etch employs an etchant source gas that includes N₂.

**6.** The method of claim 3 wherein said trench has a bottom which extends a predetermined distance from the top of the upper surface of the insulator layer

**7.** The method of claim 6 further comprising etching in accordance with selected etch parameters through said insulating material at said bottom of said trench.

**8.** The method of claim 7 wherein at least one of said selected parameters includes using an etchant source gas that comprises C₄F₈.

**9.** The method of claim 7 wherein said selected parameters include a quantity of O₂ etchant source gas.

**10.** The method of claim 1 wherein said substrate represents a silicon wafer.

**11.** The method of claim 1 wherein said first opening is achieved by reactive ion etching.

**12.** The method of claim 1 wherein said substrate is employed in the manufacture of an integrated circuit.

**13.** The method of claim 1 wherein said substrate is employed in the manufacture of a dynamic random access memory.

**14.** A method of forming a via configured for connecting an underlying device layer and an overlying conductor of a layer stack said overlying conductor being configured to be disposed in a trench formed in an insulating layer and spaced apart from said underlying device layer by insulating material at a bottom of said trench, said method comprising:
depositing a hard mask layer composed of silicon oxynitride having a first opening corresponding to said trench over said top surface of said insulating layer;
depositing a soft mask layer on top of said hard mask layer; said soft mask layer having a second opening corresponding to the location of said via; and
forming a via by etching through said insulating material at said bottom of said trench down to at least said underlying device layer.

**15.** The method of claim 14 wherein said etching through said insulating material comprises etching in accordance with selected etch parameters through said insulating material at said bottom of said trench.

**16.** The method of claim 15 wherein at least one of said selected parameters includes using an etchant source gas that comprises C₄F₈.

**17.** The method of claim 15 wherein at least one of said parameters includes using an etchant source gas that comprises oxygen.

**18.** The method of claim 15 wherein at least one of said parameters includes using an etchant source gas that comprises argon and carbon monoxide.

**19.** The method of claim 14 further comprising depositing conductive material into said via and said trench to form said overlying conductor and to electrically couple said overlying conductor with said underlying device layer.

**20.** The method of claim 14 wherein said substrate is employed in the manufacture of an integrated circuit.

**22.** A method of producing self-aligned vias configured for connecting an underlying device layer and an overlying conductor of a layer stack, said overlying conductor being configured to be disposed in a trench formed in an insulating layer and spaced apart from said underlying device layer by insulating material at a bottom of said trench, said method comprising:
depositing a hard resist having a first opening corresponding to said trench over said top surface of said insulating layer;
depositing a soft resist having a second opening corresponding to the location of said via and aligned to said first opening; and
etching through said insulating layer to form a first trench having a bottom extending from said top of said insulator layer to a distance about midway of the insulator layer
forming a via by etching through said insulating material at said bottom of said first trench down to at least said underlying device layer.

**23.** The method of claim 22 wherein said substrate is employed in the manufacture of an integrated circuit.

**24.** The method of claim 22 wherein said device layer represents a conductive layer.

**25.** The method of claim 22 wherein said device layer represents a doped silicon layer.
